# EUROPEAN PATENT SPECIFICATION

(11) **EP 4 496 437 B1**
(45) Date of publication and mention of the grant of the patent: **17.12.2025**
(21) Application number: 23770273.3
(22) Date of filing: 17.02.2023
(51) Int. Cl.: C08G 59/34, C08G 59/24, C08G 59/02, C08G 59/38, C08J 5/18, C08K 3/22, C08K 3/38, C08G 59/50, C08G 59/68, C08K 5/18, H05K 1/03, H05K 1/05, C08L 63/08

(54) **EPOXY RESIN COMPOSITION FOR INTERLAYER INSULATION, RESIN SHEET FOR INTERLAYER INSULATION, LAMINATE FOR CIRCUIT BOARD, METAL BASE CIRCUIT BOARD, AND POWER MODULE**
EPOXIDHARZZUSAMMENSETZUNG FÜR ZWISCHENSCHICHTISOLIERUNG, HARZFOLIE FÜR ZWISCHENSCHICHTISOLIERUNG, LAMINAT FÜR LEITERPLATTE, LEITERPLATTE AUF METALLBASIS UND LEISTUNGSMODUL
COMPOSITION DE RÉSINE ÉPOXY POUR ISOLATION INTERCOUCHE, FEUILLE DE RÉSINE POUR ISOLATION INTERCOUCHE, STRATIFIÉ POUR CARTE DE CIRCUIT IMPRIMÉ, CARTE DE CIRCUIT IMPRIMÉ DE BASE MÉTALLIQUE ET MODULE D'ALIMENTATION

(30) Priority: 18.03.2022 JP 2022044045
(43) Date of publication of application: 22.01.2025
(73) Proprietor: NHK Spring Co., Ltd., Yokohama-shi, Kanagawa 236-0004 (JP)
(72) Inventor: MIZUNO, Katsumi, Yokohama-shi, Kanagawa 236-0004 (JP); SHIMOMURA, Kohei, Yokohama-shi, Kanagawa 236-0004 (JP); SUDO, Saki, Yokohama-shi, Kanagawa 236-0004 (JP)
(74) Representative: AWA Sweden AB
(86) International application number: PCT/JP2023/005768
(87) International publication number: WO 2023/176314

(56) References cited:
- WO-A1-2012/099131
- WO-A1-2020/194920
- WO-A1-2021/182910
- CN-A- 111 040 387
- JP-A- 2019 127 571

## Description

### FIELD

The present invention relates to an epoxy resin composition for interlayer insulation, a resin sheet for interlayer insulation, a laminate for a circuit board, a metal-based circuit board, and a power module.

### BACKGROUND

Electronics technology in recent years has shown remarkable development, and sophistication and downsizing of electric and electronic devices are rapidly progressing. Along with this, metal-based circuit boards for use in such devices that have been adapted for high-density mounting are becoming smaller and denser than ever before. Thus, various performance improvements are also required of metal-based circuit boards, and extensive efforts are being made to meet such demands.

Up to now, a resin composition adopting an epoxy resin has been widely used as a resin composition for an insulating layer constituting a metal-based circuit board. For example, Patent Document 1 discloses a resin composition obtained by adding a specific phenol-based curing agent, phenoxy resin, and rubber particles to an epoxy resin-containing composition, as a resin composition that can provide an insulating layer having a high interfacial adhesion strength to adhere to a plated conductor layer even with a small surface roughness on the insulating layer.

Resin sheets for interlayer insulation based on epoxidized polybutadiene have been also disclosed in CN 111040387 A (Patent Document 5).

Also, Patent Document 2 discloses an insulating layer having a phase-separated structure formed of an epoxy-modified acrylic rubber sea phase and an epoxy resin island phase, in which an average domain size of the island phase and a mixture ratio of the epoxy-modified acrylic rubber and the epoxy resin are adjusted to provide a printed circuit board that includes an insulating layer realizing advantageous features of both of the resin components.

An epoxy resin composition is also widely used as a sealing material in electronic component devices, and various improvements are being made so that it can fulfill the required performance to serve as the sealing material. For example, Patent Document 3 discloses a solventless type epoxy resin composition containing a liquid epoxy resin, a liquid aromatic amine-based curing agent, an epoxidized polybutadiene compound, and an inorganic filler, as a sealing epoxy resin composition having an excellent adhesiveness under high temperature and high humidity conditions. Here, an epoxidized butadiene rubber which is formed of a vinyl-1,2-bond repeating unit derived from butadiene and a 1,2-bond repeating unit obtained by epoxidizing the vinyl-1,2-bond repeating unit is used as the epoxidized polybutadiene compound.

Meanwhile, since resins have a low thermal conductivity, studies have been widely conducted for increasing the thermal conductivity of the insulating layer in metal-based circuit boards by adding an inorganic filler to the insulating layer. For example, Patent Document 4 discloses increasing the thermal conductivity of an insulating layer by adding, as an inorganic filler, boron nitride and aluminum oxide to an insulating layer, while regulating the proportion of the boron nitride to the inorganic filler to be 35% by volume or less in order to increase the adhesion strength between a metal foil and the insulating layer.

### CITATION LIST

### PATENT LITERATURE

Patent Document 1:
   Jpn. Pat. Appln. KOKAI Publication No. 2007-254709
Patent Document 2:
   Jpn. Pat. Appln. KOKAI Publication No. 2016-079367
Patent Document 3:
   Jpn. Pat. Appln. KOKAI Publication No. 2007-254709
Patent Document 4:
   Jpn. Pat. Appln. KOKAI Publication No. 2013-091179
Patent Document 5: CN 111040387 A

### SUMMARY

### TECHNICAL PROBLEM

Metal-based circuit boards are required to have a heat resistance sufficient to withstand the solder reflow process in device mounting. As such, an epoxy resin composition for interlayer insulation employed for insulating layers in metal-based circuit boards is required to have an even higher heat resistance than that of the sealing epoxy resin composition employed for sealing members. Additionally, in the midst of the demand for heat resistance of metal-based circuit boards becoming stricter due to the increase in solder reflow temperature in recent years, the insulating layers in metal-based circuit boards are required to further improve their adhered-state heat resistance and voltage resistance.

Objects of the present invention include providing an epoxy resin composition for interlayer insulation, a resin sheet for interlayer insulation, a laminate for a circuit board, a metal-based circuit board, and a power module which realize an excellent adhered-state heat resistance and which allow for the retention of good voltage resistance even after, for example, the solder reflow process.

### SOLUTION TO PROBLEM

According to one aspect of the present invention, there is provided an epoxy resin composition for interlayer insulation comprising an epoxy resin, an epoxy-modified polybutadiene compound, and an aromatic amine compound,
wherein the epoxy-modified polybutadiene compound contains a repeating unit represented by the following general formula (I), a repeating unit represented by the following general formula (II), and a repeating unit represented by the following general formula (III), and contains at least one of a repeating unit represented by the following general formula (i), a repeating unit represented by the following general formula (ii), and a repeating unit represented by the following general formula (iii):

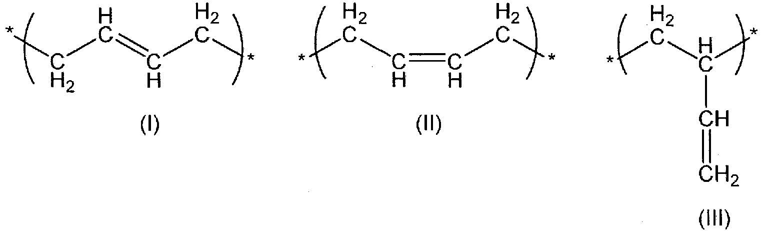

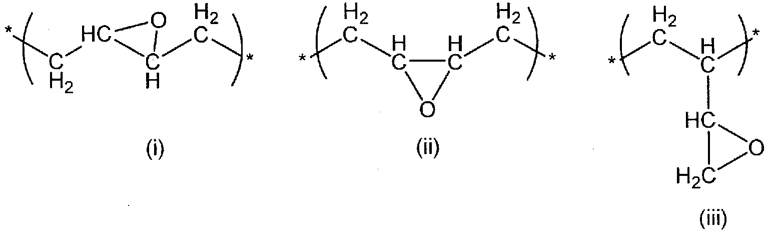

The epoxy resin composition for interlayer insulation according to the embodiment may include, as the epoxy resin, at least a bisphenol-A type diglycidyl ether.

The epoxy resin composition for interlayer insulation according to the embodiment may also include, as the aromatic amine compound, a compound represented by the following general formula (IV):

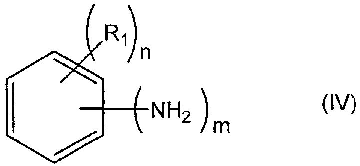

in which R₁ represents an alkyl group, m represents an integer of 2 or more, n represents an integer of 0 or more, and m and n satisfy m + n ≤ 6,
wherein if n is 2 or more, a plurality of R₁'s may be the same as or different from one another.

The epoxy resin composition for interlayer insulation according to the embodiment may also include a boron-phosphorus complex represented by the following general formula (V) and a phosphorus compound represented by the following general formula (VI): 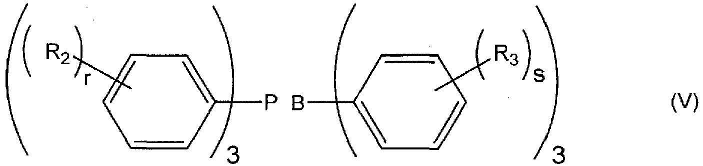
wherein in the general formula (V), R₂ and R₃ each independently represent an alkyl group, r represents an integer of 0 or more and 5 or less, and s represents an integer of 0 or more and 5 or less,
wherein if r is an integer of 2 or more, a plurality of R₂'s may be the same as or different from one another, and
if s is an integer of 2 or more, a plurality of R₃'s may be the same as or different from each other, and 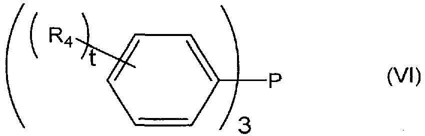
in the general formula (VI), R₄ represents an alkyl group or an alkoxy group, and t represents an integer of 0 or more and 5 or less,
wherein if t is an integer of 2 or more, a plurality of R₄'s may be the same as or different from one another.

The epoxy resin composition for interlayer insulation according to the embodiment may also include an inorganic filler.

According to another aspect of the present invention, there is provided a resin sheet for interlayer insulation including a cured product of the epoxy resin composition for interlayer insulation,
wherein the resin sheet for interlayer insulation has a phase-separated structure in which a discontinuous phase containing the epoxy-modified polybutadiene compound is dispersed in a continuous phase containing the epoxy resin.

For the resin sheet for interlayer insulation according to the embodiment, a first glass transition temperature Tg₁ attributable to the epoxy-modified polybutadiene compound may be -5 °C or lower, and a second glass transition temperature Tg₂ attributable to the epoxy resins may be 175 °C or higher.

According to still another aspect of the present invention, there is provided a laminate for a circuit board, the laminate including a metal substrate, an insulating layer provided on at least one surface of the metal substrate, and a metal foil provided on the insulating layer,
wherein the insulating layer is the above resin sheet for interlayer insulation.

According to still another aspect of the present invention, there is provided a metal-based circuit board including a metal substrate, an insulating layer provided on at least one surface of the metal substrate, and a circuit pattern provided on the insulating layer,
wherein the insulating layer is the above resin sheet for interlayer insulation.

According to still another aspect of the present invention, there is provided a power module including the above metal-based circuit board.

### ADVANTAGEOUS EFFECTS OF INVENTION

According to the present invention, an epoxy resin composition for interlayer insulation, a resin sheet for interlayer insulation, a laminate for a circuit board, a metal-based circuit board, and a power module which realize an excellent adhered-state heat resistance and which allow for the retention of good voltage resistance even after, for example, the solder reflow process are provided.

### BRIEF DESCRIPTION OF THE DRAWINGS

FIG. 1 is a graph showing behavior of a storage elastic modulus (E'), a loss elastic modulus (E"), and a loss tangent (tan δ) of a resin sheet for interlayer insulation according to one embodiment of the present invention.
FIG. 2 is a photographic image of a fracture surface of a cured product of an epoxy resin composition for interlayer insulation according to one embodiment of the present invention.
FIG. 3 is a photographic image of a fracture surface of a cured product of a comparative epoxy resin composition that employs an epoxy-modified polybutadiene compound not containing a 1,4-bond repeating unit.
FIG. 4 is a perspective view schematically showing a laminate for a circuit board according to one embodiment of the present invention.
FIG. 5 is a sectional view of the laminate for a circuit board shown in FIG. 2, taken along the line II-II.
FIG. 6 is a sectional view schematically showing a metal-based circuit board according to one embodiment of the present invention.
FIG. 7 is a sectional view schematically showing a power module according to one embodiment of the present invention.
FIG. 8 is a sectional view schematically showing a conventional power module.

### DETAILED DESCRIPTION

Embodiments of the present invention will be described in the order of an epoxy resin composition for interlayer insulation as a first embodiment, a resin sheet for interlayer insulation as a second embodiment, a laminate for a circuit board as a third embodiment, a metal-based circuit board as a fourth embodiment, and a power module as a fifth embodiment. These embodiments each depict a more specific form of one of the aspects set forth above. Note that the description will include explanations referring to the figures, and the description will use the same reference signs for the elements in the referenced figures that have the same or similar functions so that repetitive explanations will be avoided. Note also that dimensional ratios and shapes appearing in each figure may differ from actual objects.

### <Epoxy Resin Composition for Interlayer Insulation>

The epoxy resin composition for interlayer insulation according to the first embodiment (which may also be called an "epoxy resin composition" below) contains an epoxy resin, an epoxy-modified polybutadiene compound, and an aromatic amine compound.

### (Epoxy Resin)

As the epoxy resin, one or a combination of two or more known epoxy resins may be used. Examples of the epoxy resins may include: a bisphenol type epoxy resin; a phenol-novolac type epoxy resin; an ortho-cresol-novolac type epoxy resin; a biphenyl type epoxy resin; a dicyclopentadiene type epoxy resin; a diphenylfluorene type epoxy resin; their halogen-, amino group-, or alkylsubstituted products; an aromatic ring/aliphatic ring-containing epoxy resin such as a glycidyl ester type epoxy resin, a naphthalene type epoxy resin, or a heterocyclic epoxy resin; an isocyanate-modified epoxy resin; a diarylsulfone type epoxy resin; a hydroquinone type epoxy resin; a hydantoin type epoxy resin; and an epoxy resin (polyepoxy compound) containing two or more epoxy groups in molecules such as resorcinol diglycidyl ether, triglycidyl-p-aminophenol, m-aminophenol triglycidyl ether, tetraglycidyl methylenedianiline, (trihydroxyphenyl) methane triglycidyl ether, or tetraphenylethane tetraglycidyl ether.

Among these, a bisphenol type epoxy resin is preferably used as the epoxy resin in view of the controllability of a curable resin composition, heat resistance of a cured product, and so on. Specific examples of the bisphenol type epoxy resin may include a bisphenol-A type epoxy resin, a bisphenol-F type epoxy resin, a bisphenol-S type epoxy resin, and a bisphenol-AD type epoxy resin. Among these, a bisphenol-A type epoxy resin is preferably used, and a bisphenol-A type diglycidyl ether is even more preferably used, since a more excellent controllability of a curable resin composition and a more excellent heat resistance of a cured product would be attained.

The epoxy resin suitably used in the present embodiment has a weight average molecular weight (Mw) of, in one example, 100 or more and 10000 or less, and in another example, 200 or more and 5000 or less. The weight average molecular weight (Mw) of the epoxy resin being within such a range is preferred from the viewpoint of adhesion and voltage resistance, since this allows the resin to flow during adhesion and easily follow irregularities, so as to facilitate void elimination. The "weight average molecular weight" here refers to a polystyrene equivalent value measured by gel permeation chromatography (GPC).

The epoxy resin suitably used in the present embodiment has an epoxy equivalent of, in one example, 50 or more and 2000 or less, and in another example, 100 or more and 1000 or less. The epoxy equivalent of the epoxy resin being within such a range can reduce the time required for curing and also provide a high Tg. (Epoxy-Modified Polybutadiene Compound)

The epoxy-modified polybutadiene compound is an epoxy-modified butadiene rubber obtained by subjecting a polymer (butadiene rubber) formed of 1,3-butadiene to epoxy modification. This butadiene rubber is a polymer in which addition polymerization of 1,3-butadienes, i.e., conjugated diene monomers, has taken place. As such, the epoxy-modified polybutadiene compound used in the present embodiment (which may also be called an "epoxy-modified butadiene rubber" or the like below) contains, in its main chain, a trans-1,4-bond butadiene-derived repeating unit represented by the following general formula (I), a cis-1,4-bond butadiene-derived repeating unit represented by the following general formula (II), and a vinyl-1,2-bond butadiene-derived repeating unit represented by the following general formula (III), according to the bonding mode of the monomers.

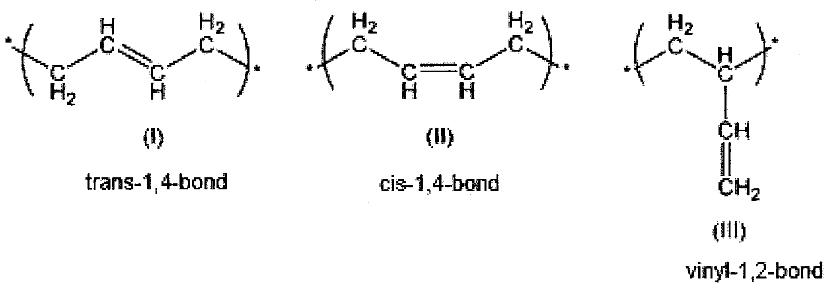

In the epoxy-modified polybutadiene compound used in the present embodiment, at least one of the repeating units represented by the respective general formulae (I) to (III) is epoxidized. More specifically, the epoxy-modified polybutadiene compound according to the present embodiment contains at least one of a 1,4-bond repeating unit represented by the following general formula (i), a 1,4-bond repeating unit represented by the following general formula (ii), and a 1,2-bond repeating unit represented by the following general formula (iii), as the epoxidized butadiene-derived repeating unit.

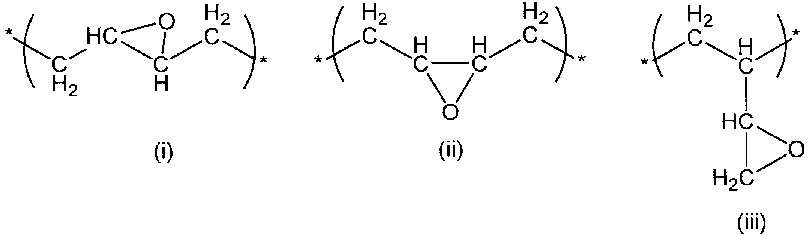

In the description below, a repeating unit that belongs to Group A consisting of the repeating units represented by the respective formulae (I), (II), (i) and (ii) will be referred to as a "1,4-bond repeating unit", and a repeating unit that belongs to Group B consisting of the repeating units represented by the respective formulae (III) and (iii) will be referred to as a "1,2-bond repeating unit".

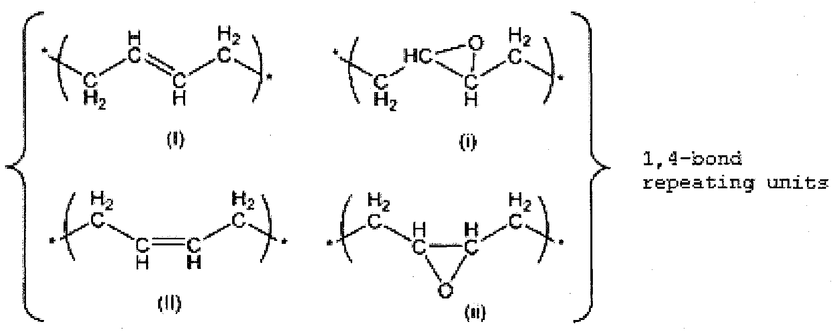

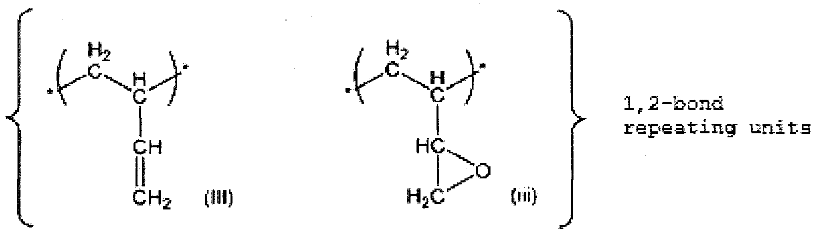

While the epoxy-modified polybutadiene compound used in Patent Document 3 is an epoxy-modified butadiene rubber composed of only 1,2-bond repeating units, the epoxy-modified polybutadiene compound used in the present embodiment also contains, as described above, the 1,4-bond repeating units in addition to the 1,2-bond repeating unit. That is, the epoxy-modified polybutadiene compound contains, as the essential features, the 1,4-bond repeating units represented by the respective general formulae (I) and (II) from among the 1,4-bond repeating units belonging to the group A, and optionally contains the 1,4-bond repeating unit or units represented by the respective general formulae (i) and/or (ii). The epoxy resin composition according to the present embodiment, which contains such an epoxy-modified polybutadiene compound with 1,4-bond repeating units as the epoxy-modified butadiene rubber component used in combination with the epoxy resin, can provide a resin sheet for interlayer insulation that realizes an excellent adhered-state heat resistance and also allows for the retention of good voltage resistance even after, for example, a solder reflow process.

For the present embodiment, the mixture ratio (molar ratio) between the 1,4-bond repeating units and the 1,2-bond repeating unit to be contained in the epoxy-modified polybutadiene compound is preferably 5:5 to 0.5:9.5 according to one example, and more preferably 4:6 to 1:9 according to another example.

The epoxy-modified polybutadiene compound containing the 1,4-bond repeating units may be a commercially available product or a product produced by a known method. The epoxy-modified polybutadiene compound suitably used in the present embodiment has a number average molecular weight (Mn) of, in one example, 500 or more and 10000 or less, and in another example, 1000 or more and 7000 or less. The number average molecular weight of the epoxy-modified polybutadiene compound being within such a range can provide a good solubility in solvents and a moderate flexibility.

The epoxy-modified polybutadiene compound suitably used in the present embodiment has an epoxy equivalent of, in one example, 50 or more and 500 or less, and in another example, 100 or more and 350 or less. The epoxy equivalent of the epoxy-modified polybutadiene compound being within such a range is preferred since the adhesion with the epoxy resin in the phase-separated state can be suitably adjusted.

For the present embodiment, the mixture ratio of the epoxy-modified polybutadiene compound in the epoxy resin composition may be, in one example, 5 parts by mass or more and 40 parts by mass or less, and in another example, 10 parts by mass or more and 30 parts by mass or less, with the sum of the epoxy resin, the aromatic amine compound, and the epoxy-modified polybutadiene compound assumed to be 100 parts by mass.

### (Aromatic Amine Compound)

The epoxy resin composition according to the present embodiment contains an aromatic amine compound as a curing agent. The aromatic amine compound preferably has two or more amino group substitutions on the aromatic ring, and preferably includes an aromatic amine compound represented by, for example, the following general formula (IV).

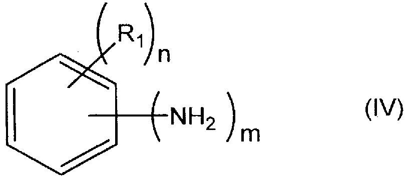

In the general formula (IV), R₁ represents an alkyl group, m represents an integer of 2 or more, n represents an integer of 0 or more, and m and n satisfy m + n ≤ 6. If n is an integer of 2 or more, a plurality of R₁'s may be the same as or different from one another.

The number of amino group substitutions on the benzene ring, i.e., m, is 2 or more and 6 or less, and it may be 2 or more and 5 or less, or may be 2 or 3, or may be 2. If m is 2, the two amino groups on the benzene ring are preferably provided in such an arrangement that one is at the meta position or the ortho position with respect to the other.

R₁ is an optional substituent on the benzene ring. The number of carbon atoms in the alkyl group represented by R₁ may be 1 to 4, or may be 1 or 2. Specific examples of the alkyl group may include a methyl group, an ethyl group, a propyl group, and a butyl group. The number of R₁ substitutions on the benzene ring, i.e., n, is 0 or more and 4 or less, and it may be 0 or more and 3 or less, or may be 1 or more and 3 or less.

The aromatic amine compound represented by the general formula (IV) has a small steric hindrance, and therefore, it has an excellent curability improving effect and can provide satisfactory performance even in a short curing time. Also, the aromatic amine compound represented by the general formula (IV) takes a liquid form at normal temperature, and therefore, it dissolves well in a solvent and can be easily handled.

Specific examples of the aromatic amine compound represented by the general formula (IV) may include diethyltoluenediamines represented by, for example, the following formulae: 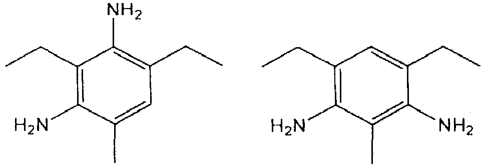 Specific examples of the aromatic amine compound represented by the general formula (IV) may also include 1,2-phenylenediamine, 1,3-phenylenediamine, 2,4-diaminotoluene, 2,6-diaminotoluene, 2,3-diaminotoluene, 3,4-diaminotoluene, 2,4,6-trimethyl-1,3-phenylenediamine, 1,2,4-triaminobenzene, 4,5-dimethyl-1,2-phenylenediamine, 1,4-phenylenediamine, 2,3,5,6-tetramethyl-1,4-phenylenediamine, and the like.

Each of such aromatic amine compounds represented by the general formula (IV) may be used alone, or two or more of them may be used in combination. These aromatic amine compounds are not particularly limited in terms of production, and commercially available products may be adopted.

For the present embodiment, the mixture ratio of the aromatic amine compound represented by the general formula (IV) in the epoxy resin composition may be, in one example, 5 parts by mass or more and 50 parts by mass or less, and in another example, 10 parts by mass or more and 40 parts by mass or less, with the sum of the epoxy resin and the aromatic amine compound assumed to be 100 parts by mass.

### (Curing Accelerator)

It is preferable that the epoxy resin composition according to the present embodiment contain a curing accelerator. Examples of the curing accelerator which may be adopted in the present embodiment may include a boron-phosphorus complex represented by the following general formula (V).

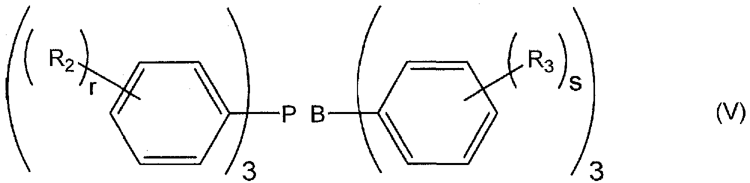

In the general formula (V), R₂ and R₃ each independently represent an alkyl group, r represents an integer of 0 or more and 5 or less, and s represents an integer of 0 or more and 5 or less. If r is an integer of 2 or more, a plurality of R₂'s may be the same as or different from one another. If s is an integer of 2 or more, a plurality of R₃'s may be the same as or different from one another.

R₂ and R₃ are optional substituents on the benzene ring. Specific examples of the alkyl groups represented by R₂ and R₃ may include a methyl group and an ethyl group.

The number of R₂ substitutions on the P atom-substituted benzene ring, i.e., r, is 0 or more and 5 or less, and it may be 0 or more and 3 or less, or may be 0 or more and 2 or less, or may be 0 or 1. If r is 1, the alkyl group represented by R₂ may be arranged at any of the ortho position, the meta position, and the para position with respect to the P atom.

The number of R₃ substitutions on the B atom-substituted benzene ring, i.e., s, is 0 or more and 5 or less, and it may be 0 or more and 3 or less, or may be 0 or more and 2 or less, or may be 0.

Specific examples of the boron-phosphorus complex represented by the general formula (V) may include triphenylphosphine triphenylborate (TPP-S) and trisparamethylphenylphosphine triphenylborate (TPTP-S) represented by, for example, the following formulae. Note that, in TPTP-S, the methyl group may be arranged at any of the ortho position, the meta position, and the para position with respect to the P atom.

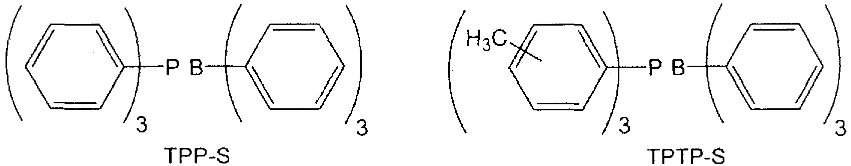

As one form, the epoxy resin composition according to the present embodiment preferably contains TPP-S and/or TPTP-S as a curing accelerator.

Each of such boron-phosphorus complexes represented by the general formula (V) may be used alone, or two or more of them may be used in combination. The boron-phosphorus complexes represented by the general formula (V) are not particularly limited in terms of production, and commercially available products may be adopted.

For the present embodiment, the mixture ratio of the boron-phosphorus complex represented by the general formula (V) in the epoxy resin composition may be, in one example, 0.01 parts by mass or more and 5 parts by mass or less, and in another example, 0.1 parts by mass or more and 5 parts by mass or less, with the sum of the epoxy resin, the aromatic amine compound, and the epoxy-modified polybutadiene compound assumed to be 100 parts by mass.

Examples of other curing accelerators which may be contained in the epoxy resin composition according to the present embodiment may include a phosphorus compound represented by the following general formula (VI). In the present embodiment, the phosphorus compound represented by the following general formula (VI) is preferably used in combination with the above described boron-phosphorus complex represented by the general formula (V).

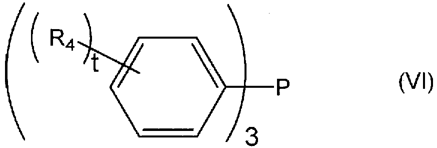

In the general formula (VI), R₄ represents an alkyl group or an alkoxy group, and t represents an integer of 0 or more and 5 or less. If t is an integer of 2 or more, a plurality of R₄'s may be the same as or different from one another.

R₄ is an optional substituent on the benzene ring. Specific examples of the alkyl group represented by R₄ may include a methyl group, an ethyl group, and a propyl group. Specific examples of the alkoxy group represented by R₄ may include a methoxy group and a butoxy group.

The number of R₄ substitutions on the benzene ring, i.e., t, is 0 or more and 5 or less, and it may be 0 or more and 4 or less, or may be 0 or more and 2 or less, or may be 0.

Specific examples of the phosphorus compound represented by the general formula (VI) may include triphenylphosphine (TPP) represented by, for example, the following formula.

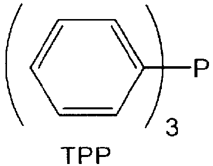

Each of such phosphorus compounds represented by the general formula (VI) may be used alone, or two or more of them may be used in combination of two or more kinds thereof. The phosphorus compounds represented by the general formula (VI) are not particularly limited in terms of production, and commercially available products may be adopted.

In the case where the epoxy resin composition according to the present embodiment contains the aromatic amine compound represented by the general formula (IV) as a curing agent, and the boron-phosphorus complex represented by the general formula (V) and the phosphorus compound represented by the general formula (VI) as curing accelerators, all of the voltage resistance, the adhesiveness, and the heat resistance of the cured film obtained in a short curing time are greatly improved. The mechanism has not been made entirely apparent, but the following is presumed. A curing reaction of the resin is not promoted at normal temperature, and a rapid curing reaction takes place only on heating; therefore, it would be possible to sufficiently increase the molecular weight in a short time through a drying step. Also, with its superior controllability, it would be possible to set an appropriate melt viscosity for a pressing operation.

For the present embodiment, the mixture ratio of the phosphorus compound represented by the general formula (VI) in the epoxy resin composition may be, in one example, 0.01 parts by mass or more and 5 parts by mass or less, and in another example, 0.05 parts by mass or more and 5 parts by mass or less, with the sum of the epoxy resin, the aromatic amine compound, and the epoxy-modified polybutadiene compound assumed to be 100 parts by mass.

Also, for determining the added amount of the phosphorus compound represented by the general formula (VI), it is preferable to take into consideration the added amount of the boron-phosphorus complex represented by the general formula (V). As one form, [total mass of the phosphorus compound represented by the general formula (VI) / total mass of the boron-phosphorus complex represented by the general formula (V)] is preferably set to the range of 0.002 to 5, and more preferably set to the range of 0.1 or more and less than 1.

Also, the mixture ratio of a total of the boron-phosphorus complex represented by the general formula (V) and the phosphorus compound represented by the general formula (VI) in the epoxy resin composition may be, in one example, 0.5 parts by mass or more and 10 parts by mass or less, and in another example, 1 part by mass or more and 10 parts by mass or less, with the sum of the epoxy resin, the aromatic amine compound, and the epoxy-modified polybutadiene compound assumed to be 100 parts by mass.

### (Inorganic Filler)

The epoxy insulating composition according to the present embodiment preferably contains an inorganic filler. Examples of the inorganic filler may include alumina, aluminum nitride, boron nitride, silicon nitride, magnesium oxide, and silicon oxide. One or a combination of two or more selected from these are preferably used.

In the system of the epoxy resin composition according to the present embodiment with the inorganic filler contained, heat generating reactions occurring in the course of curing tend to be suppressed by the inorganic filler. More specifically, there are expected problems, such as the delay in curing reactions due to the inorganic filler absorbing the reaction heat, and blocking of curing reactions of the thermosetting resin depending on the surface functional group of the inorganic filler. To address these, a surface-treated inorganic filler may be used, and it is also preferable to use the inorganic filler in appropriate combination with the curing accelerator or accelerators mentioned above. As the surface treatment of the inorganic filler, for example, the surface of the inorganic filler may be modified with a functional group that can be chemically bonded to a thermosetting resin through reaction, or with a functional group having a high compatibility with a thermosetting resin (e.g., a cyanate group, an epoxy group, an amino group, a hydroxyl group, a carboxyl group, a vinyl group, a styryl group, a methacryl group, an acryl group, an ureido group, a mercapto group, a sulfide group, an isocyanate group, etc.), which may be conducted by, for example, a silane coupling treatment or a plasma treatment.

In the case where the epoxy resin composition according to the present embodiment contains the inorganic filler, the mixture ratio thereof (if two or more inorganic fillers are contained, the mixture ratio of their total) is preferably from 30% by volume to 90% by volume, and more preferably from 50% by volume to 85% by volume, based on the total volume of the epoxy resin, the epoxy-modified polybutadiene compound, and the aromatic amine compound. A too-low filling rate would result in failure of obtaining desired thermal conductivity and also in occurrence of the inorganic filler sediment. On the other hand, a toohigh filling rate would make the viscosity too high, resulting in failure of obtaining a uniform coating film and an increase in pore defects.

For the epoxy resin composition according to the present embodiment, at least boron nitride (BN) is contained as the inorganic filler in a predetermined amount, and the ratio of the boron nitride to the inorganic filler here is adjusted to a predetermined value or more, so that the heat resistant adhesion can be further improved. More specifically, by setting the ratio of the inorganic filler to the total volume of the epoxy resin, the epoxy-modified polybutadiene compound, and the aromatic amine compound in the epoxy resin composition to 50% by volume or more and 85% by volume or less, and also setting the ratio of boron nitride to the inorganic filler in this case (which may also be called a "BN ratio" below) to preferably 60% by volume or more, the heat resistant adhesion can be further improved. The BN ratio is more preferably 65% by volume or more, and even more preferably 70% by volume or more.

This is truly surprising in view of the public knowledge that boron nitride has almost no functional groups on its surface that contribute to adhesion with resins, and as such, an increase in the ratio of boron nitride in the inorganic filler would decrease the adhesion strength (see, for example, Patent Document 4, claims, paragraphs 0078 and 0123, etc.). It is presumed that this phenomenon is an effect attributable to the combined use of the epoxy-modified polybutadiene compound and the boron nitride, particulars of which will be described later.

From the viewpoint of adhered-state heat resistance, the upper limit of the BN ratio for the inorganic filler is not particularly limited. The upper limit of the BN ratio may be, in one example, 100% by volume, and in another example, 95% by volume, and in yet another example, 90% by volume. Note that the BN ratio being 100% by volume means that the inorganic filler contains only one kind of boron nitride.

### (Solvent)

The epoxy resin composition according to the present embodiment preferably contains a solvent. A resin sheet for interlayer insulation formed of a cured product of the epoxy resin composition according to the present embodiment has a phase-separated structure in which discontinuous phases containing the epoxy-modified polybutadiene compound are dispersed in a continuous phase containing the epoxy resin. In order to form such a phase-separated structure, it is preferable that the epoxy resin and the epoxy-modified polybutadiene compound in the solvent-containing epoxy resin composition are dissolved in the solvent so as to be placed in a compatibilized state where they are mutually and uniformly dispersed. If, from this state, heat application is conducted to cause the curing, reaction between the epoxy resin and the amine curing agent occurs to increase the molecular weight, thereby forming the continuous phase, while the epoxy-modified polybutadiene compound having a lower reactivity than the epoxy resin and the amine curing agent partially aggregates to form the discontinuous phase.

Thus, the solvent for use in the epoxy resin composition is preferably a solvent in which the epoxy resin and the epoxy-modified polybutadiene compound can dissolve. Examples of such a solvent may include: amide-based solvents such as N,N-dimethylformamide (DMF), N,N-dimethylacetamide, and N-methyl-2-pyrrolidone (NMP); ether-based solvents such as 1-methoxy-2-propanol and ethylene glycol monomethyl ether; ketone-based solvents such as methyl ethyl ketone (MEK), methyl isobutyl ketone (MIBK), cyclohexanone, and cyclopentanone; and aromatic solvents such as toluene and xylene. As for the manner of use, one kind of such a solvent may be used alone, or two or more kinds may be used in combination.

### (Other Components)

The epoxy resin composition according to the present embodiment may additionally contain other components. Examples of such other components may include coupling agents such as a silane coupling agent and a titanium coupling agent, an ion adsorbent, an anti-settling agent, an anti-hydrolysis agent, a leveling agent, and an anti-oxidant.

### <Resin Sheet for Interlayer Insulation>

The resin sheet for interlayer insulation according to the second embodiment is a sheet-like member formed of a cured product of the epoxy resin composition for interlayer insulation according to the above described first embodiment, and is obtained by, for example, heating and curing a coating film made of the solvent-containing epoxy resin composition. The resin sheet for interlayer insulation according to the present embodiment has a phase-separated structure in which discontinuous phases containing the epoxy-modified polybutadiene compound are dispersed in a continuous phase containing the epoxy resin. The mechanism by which such a phase-separated structure is formed is as described above. That is, from the compatibilized state where the epoxy resin and the epoxy-modified polybutadiene compound have been dissolved in a solvent and are mutually and uniformly dispersed, the curing is advanced under heat application so as to increase the viscosity of the epoxy-modified polybutadiene compound along with its partial increase in molecular weight, thereby forming discontinuous phases (island portions), while causing the epoxy resin having a lower viscosity to form a continuous phase (sea portion); as a result, the phase-separated structure (sea-island structure) in which the discontinuous phases (island portions) containing the epoxy-modified polybutadiene compound are dispersed in the continuous phase (sea portion) containing the epoxy resin is created.

The resin sheet for interlayer insulation according to the present embodiment is formed from the epoxy resin composition according to the first embodiment, which contains the above described epoxy-modified polybutadiene compound containing 1,4-bond repeating units; therefore, the resin sheet for interlayer insulation is excellent in heat resistant adhesion and can retain good voltage resistance even after, for example, a solder reflow process. This mechanism will be explained with reference to the behavior of a loss tangent (tan δ) obtained by dynamic viscoelastic measurement, i.e., dynamic mechanical analysis (DMA) .

For the resin sheet for interlayer insulation according to the present embodiment, a glass transition temperature Tg may be obtained by the dynamic mechanical analysis (DMA). More specifically, using a dynamic mechanical analyzer, a storage elastic modulus (E') and a loss elastic modulus (E") of a test sample of the resin sheet for interlayer insulation are obtained while changing the measurement temperature. The temperature at which the loss tangent (tan δ) expressed by the ratio of the loss elastic modulus (E") to the storage elastic modulus (E'), i.e., E'' / E', shows the peak top (maximum value) is determined to be the glass transition temperature Tg of the resin sheet for interlayer insulation.

The loss tangent (tan δ) of the resin sheet for interlayer insulation, which has a phase-separated structure including a continuous phase of the epoxy resin and a discontinuous phase of the epoxy-modified polybutadiene compound incompatible with the epoxy resin, shows a first peak at a first glass transition temperature Tg₁ attributable to the epoxy-modified polybutadiene compound and a second peak at a second glass transition temperature Tg₂ attributable to the epoxy resin. Here, the first glass transition temperature Tg1 and the second glass transition temperature Tg2 are in the relationship Tg₁ < Tg₂. In the description below, the first glass transition temperature Tg₁ attributable to the epoxy-modified polybutadiene compound may also be called "Tg₁ of the epoxy-modified butadiene rubber phase" and the second glass transition temperature Tg₂ attributable to the epoxy resin may also be called "Tg₂ of the epoxy resin phase".

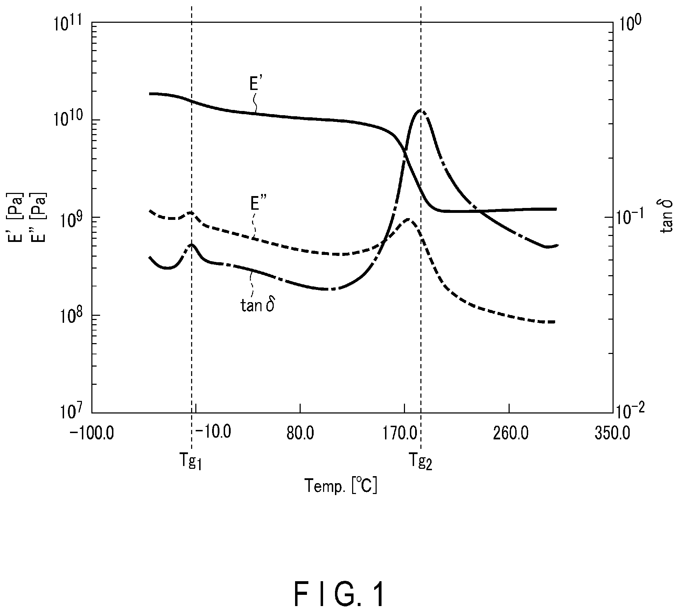

FIG. 1 is a graph showing behavior of the storage elastic modulus (E'), the loss elastic modulus (E"), and the loss tangent (tan δ) obtained by the dynamic mechanical analysis (DMA) for the resin sheet for interlayer insulation produced using the epoxy resin composition according to the first embodiment. To be more specific, it is a graph showing behavior of the storage elastic modulus (E'), the loss elastic modulus (E"), and the loss tangent (tan δ) obtained by the dynamic mechanical analysis (DMA) for an insulating layer (the resin sheet for interlayer insulation) produced using an epoxy resin composition 1 prepared in later described Example 1. This insulating layer contains bisphenol-A type diglycidyl ether as the epoxy resin, and an epoxy-modified butadiene rubber containing 1,4-bond repeating units and a 1,2-bond repeating unit as the epoxy-modified polybutadiene compound.

With a great deal of effort in research, the inventors of the present invention have found that in the case where the epoxy-modified polybutadiene compound which further contains 1,4-bond repeating units is used as the epoxy-modified butadiene rubber component incompatible with the epoxy resin, the Tg₁ of the epoxy-modified butadiene rubber phase is shifted toward the lower temperature side and the Tg₂ of the epoxy resin phase is shifted toward the high temperature side, providing a larger difference between the Tg₁ and the Tg₂ as compared to the case of using an epoxy-modified polybutadiene compound composed of a 1,2-bond repeating unit as employed in Patent Document 3.

The lower the Tg₁ of the epoxy-modified butadiene rubber phase, the less the thermal expansion in the temperature range from this Tg₁ to the Tg₂ of the epoxy resin phase. Also, the thermal expansion suddenly becomes prominent in the temperature range higher than the Tg₂, and for this reason, the low-level expansion is more successfully maintained with a higher Tg₂ of the epoxy resin phase. As such, a larger difference between the Tg₁ and the Tg₂ can better suppress the thermal expansion of the insulating layer (the resin sheet for interlayer insulation) until it reaches the Tg₂ of the epoxy resin phase during, for example, treatment such as a solder reflow process, and therefore, the resin sheet for interlayer insulation according to the present embodiment can enhance the adhered-state heat resistance and can retain good voltage resistance at a high level. In the description below, increasing the difference between the Tg₁ and the Tg₂ may be called "creation of a low thermal expansion state".

As described above, use of boron nitride (BN), i.e., an inorganic filler, in combination with the epoxy-modified polybutadiene compound further improves the adhered-state heat resistance provided that the boron nitride (BN) is mixed in the epoxy resin composition in a predetermined amount and the ratio (BN ratio) of the boron nitride (BN) to the inorganic filler is set to be high. The inventors have confirmed that, in this case, the difference between the Tg₁ and the Tg₂ becomes even larger and the creation of a low thermal expansion state of the insulating layer is further promoted.

For the resin sheet for interlayer insulation according to the present embodiment, the first glass transition temperature Tg₁ attributable to the epoxy-modified polybutadiene compound is, in one example, -5 °C or lower, and in another example, -10 °C or lower. Also, the second glass transition temperature Tg₂ attributable to the epoxy resin is, in one example, 175 °C or higher, and in another example, 180 °C or higher.

The presence of the phase-separated structure including a continuous phase of the epoxy resin and a discontinuous phase of the epoxy-modified polybutadiene compound in the resin sheet for interlayer insulation according to the present embodiment can be confirmed from the loss tangent (tan δ) having non-overlapping peaks as shown in FIG. 1, namely, a first peak at the first glass transition temperature Tg₁ attributable to the epoxy-modified polybutadiene compound and a second peak at the second glass transition temperature Tg₂ attributable to the epoxy resin.

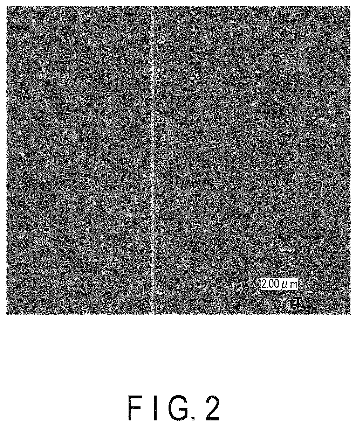

The presence of the phase-separated structure in the resin sheet for interlayer insulation according to the present embodiment may also be confirmed by conducting microscopic observation and/or scattering measurement, in addition to such a loss tangent (tan δ). In microscopic observation, the phase-separated structure can be confirmed with a scanning electron microscope (SEM), an atomic force microscope, an optical microscope, a transmission electron microscope, and so on. In scattering measurement, the phase-separated structure can be confirmed through grazing incidence small angle X-ray scattering measurement, elemental analysis, energy dispersive X-ray analysis, an electron probe microanalyzer, X-ray photoelectron spectroscopy, etc. While details will be described later, reference is made to FIG. 2, which is a photographic image of a fracture surface of a cured product of the epoxy resin composition for interlayer insulation according to the present embodiment, containing no inorganic filler, and it can be seen that the phase-separated structure has been formed.

Note that, in the instance where the resin sheet for interlayer insulation according to the present embodiment contains the inorganic filler, the inorganic filler is present irrespective of the difference between the discontinuous phase and the continuous phase. In other words, the inorganic filler may be present in the discontinuous phases, and may also be present in the continuous phase.

### <Laminate for Circuit Board>

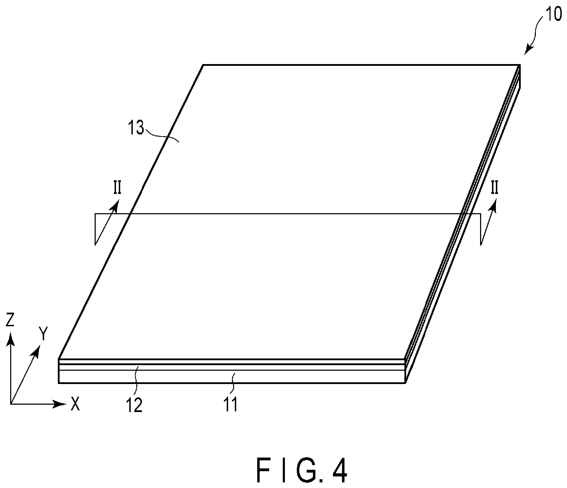

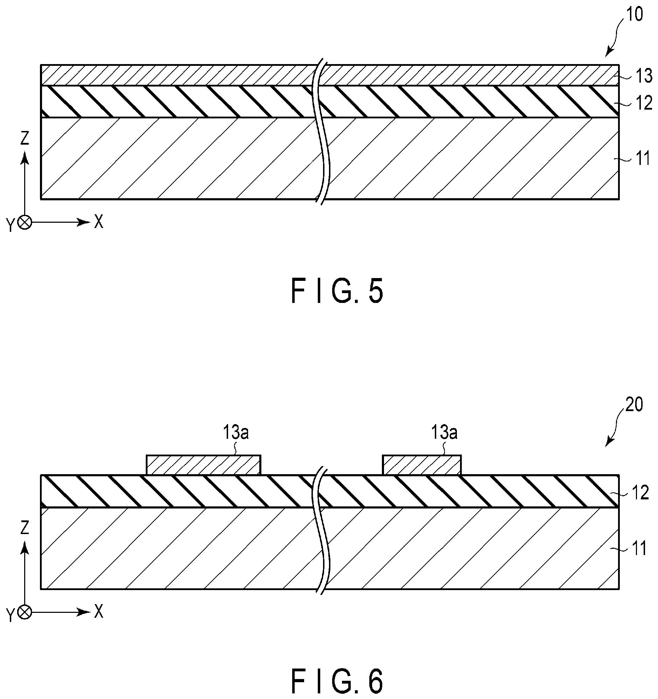

The laminate for a circuit board according to the third embodiment includes a metal substrate, an insulating layer provided on at least one surface of the metal substrate, and a metal foil provided on the insulating layer. FIG. 4 is a perspective view schematically showing the laminate for a circuit board according to the present embodiment, and FIG. 5 is a sectional view of the laminate for a circuit board shown in FIG. 4, taken along the line II-II. The laminate 10 for a circuit board shown in FIGS. 4 and 5 has a three-layer structure in which an insulating layer 12 is formed on one surface of a metal substrate 11 and a metal foil 13 is formed on the insulating layer 12. In one or more other embodiments, the laminate 10 for a circuit board may have a five-layer structure in which insulating layers 12 are formed on the respective surfaces of the metal substrate 11 and metal foils 13 are further formed on the respective insulating layers 12. Note that FIGS. 4 and 5 assume X and Y directions which are parallel to the major surface of the metal substrate 2 and orthogonal to each other, and a Z direction which represents a thickness direction perpendicular to the X and Y directions. While FIGS. 4 and 5 illustrate one exemplary form of the laminate 10 for a circuit board that has a rectangular shape, the laminate 10 for a circuit board may have a different shape.

In the laminate 10 for a circuit board, the metal substrate 11 is made of, for example, a single metal or an alloy. As a material of the metal substrate 11, for example, aluminum, iron, copper, an aluminum alloy, or stainless steel may be used. The metal substrate 11 may further contain a non-metal such as carbon. For example, the metal substrate 11 may contain carbon-composite aluminum. Also, the metal substrate 11 may have a single-layer or a multi-layer structure.

The metal substrate 11 has a high thermal conductivity. Typically, the metal substrate 11 has a thermal conductivity of 60W·m⁻¹·K⁻¹ or more. The metal substrate 11 may be flexible or non-flexible. The metal substrate 11 may have a thickness in the range of, for example, 0.2 mm to 5 mm.

The metal foil 13 is provided on the insulating layer 12. The metal foil 13 faces the metal substrate 11 with the insulating layer 12 interposed therebetween. The metal foil 13 is made of, for example, a single metal or an alloy. As a material of the metal foil 13, for example, copper or aluminum may be used. The metal foil 13 may have a thickness in the range of, for example, 10 µm to 500 µm.

The insulating layer 12 is the resin sheet for interlayer insulation according to the second embodiment, which is a cured product of the epoxy resin composition according to the first embodiment. Thus, the insulating layer 12 has a phase-separated structure including a continuous phase of the epoxy resin and a discontinuous phase of the epoxy-modified polybutadiene compound. The insulating layer 12 has a storage modulus (E') showing, according to the dynamic mechanical analysis (DMA), the behavior as shown in FIG. 1 and involves a large difference between the first glass transition temperature Tg₁ attributable to the epoxy-modified polybutadiene compound and the second glass transition temperature Tg₂ attributable to the epoxy resin, and therefore, it can realize excellent heat resistant adhesion and retain good voltage resistance at a high level. The insulating layer 12 may have a thickness in the range of, for example, 50 µm to 300 µm.

The laminate 10 for a circuit board may be produced by, for example, the following method.

First, the epoxy resin composition for interlayer insulation according to the above described embodiment is applied to at least one of the metal substrate 11 and the metal foil 13 to form a coating film. For application of the epoxy resin composition, for example, a roll coating method, a bar coating method, or a screen printing method may be used. The application may be conducted in a continuous manner or a single plate manner. The coating film is subjected to drying as necessary.

Next, the metal substrate 11 and the metal foil 13 are superposed together so as to face each other with the coating film interposed therebetween. They are then hot-pressed. The laminate 10 for a circuit board is thus obtained.

This method forms the coating film by applying the epoxy resin composition according to the embodiment to at least one of the metal substrate 11 and the metal foil 13; however, as another form, it is also possible to form a coating film in advance by applying the epoxy resin composition to a base material such as a PET film and subjecting it to drying, and to thermally transfer it to one of the metal substrate 11 and the metal foil 13.

### <Metal-Based Circuit Board>

Next, the metal-based circuit board according to the fourth embodiment will be described.

FIG. 6 is a sectional view schematically showing the metal-based circuit board according the fourth embodiment. The metal-based circuit board 20 shown in FIG. 6 includes the metal substrate 11, the insulating layer 12, and a circuit pattern 13a in this order. The metal-based circuit board 20 is obtained from the laminate 10 for a circuit board according to the third embodiment as shown in FIGS. 4 and 5, and the circuit pattern 13a is obtained by patterning the metal foil 13 of the laminate 10 for a circuit board. In one example, this patterning is realized by forming a mask pattern on the metal foil 13 and removing the exposed portions of the metal foil 13 by etching. The metal-based circuit board 20 may be obtained by, for example, performing such patterning on the metal foil 13 of the laminate 10 for a circuit board and subjecting the resultant to processes such as cutting and drilling as necessary.

The metal-based circuit board 20 according to the present embodiment is obtained from the above described laminate 10 for a circuit board and includes the insulating layer 12 constituted by the resin sheet for interlayer insulation according to the second embodiment, and therefore, the metal-based circuit board 20 has excellent heat resistant adhesion and can retain good voltage resistance even after, for example, a solder reflow process.

### <Power Module>

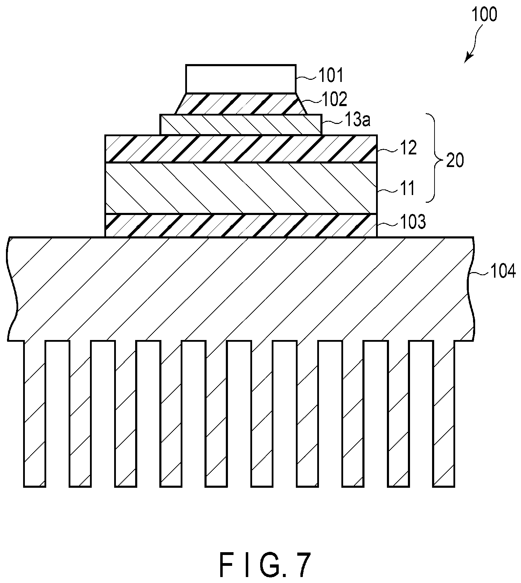

FIG. 7 is a sectional view schematically showing a power module 100 according to the fifth embodiment. This power module 100 includes the metal-based circuit board 20 according to the fourth embodiment, which includes the metal substrate 11, the insulating layer 12, and the circuit pattern 13a. Therefore, the power module 100 according to the present embodiment has excellent heat resistant adhesion and can retain good voltage resistance even after, for example, a solder reflow process. At present, where power devices are becoming more sophisticated and they tend to generate higher temperature heat, the module according to the present embodiment of the present invention can be suitably used to cope with even the temperature ranges that have not permitted the conventional power modules to be employed.

In the power module 100 shown in FIG. 7, "101" denotes a power device, "102" denotes a solder layer, "103" denotes a heat dissipation sheet, and "104" denotes a heat sink.

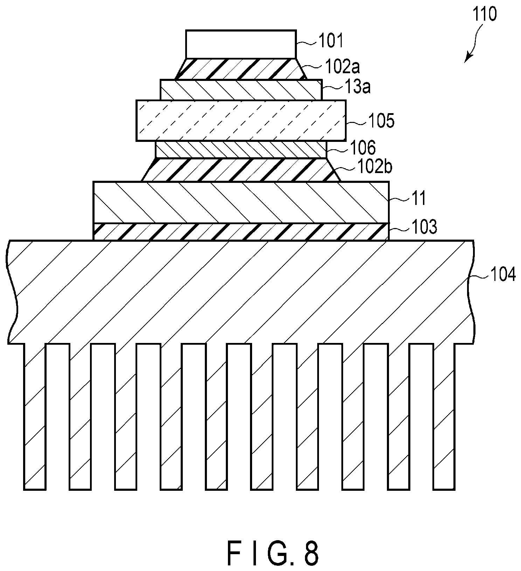

Moreover, the power module 100 according to the present embodiment, by adopting the metal-based circuit board 20 according to the embodiment, includes a reduced number of components (layers) as compared to the conventional power module 110, of which an example is shown in FIG. 8, and the entire thickness is reduced accordingly; therefore, the power module 100 according to the present embodiment allows for a more compact design with lower thermal resistance. There is also an advantage that the assembly is facilitated since processes such as drilling and cutting are allowed to be easily carried out.

Note that, in the conventional power module 110 shown in FIG. 8, "101" denotes a power device, "102a" denotes a first solder layer, "13a" denotes a circuit pattern, "105" denotes a ceramic substrate, "106" denotes a metallized layer, "102b" denotes a second solder layer, "11" denotes a metal substrate, "103" denotes a heat dissipation sheet, and "104" denotes a heat sink.

### EXAMPLES

### <Preparation of Epoxy Resin Compositions>

Epoxy resin compositions 1 to 4 and 101 to 104 were prepared by the following method.

### (Example 1)

A mixture 1 was obtained by mixing bisphenol-A type diglycidyl ether, an epoxy-modified polybutadiene compound 1, diethyltoluenediamine as a curing agent, triphenylphosphine triphenylborane as a curing accelerator 1, and triphenylphosphine as a curing accelerator 2, in a mixture ratio shown in Table 1 below. Note that numerical values of the mixture ratios in Table 1 indicate parts by mass except for the inorganic fillers.

Next, a mixture 2 was obtained by adding, to the obtained mixture 1, an alumina filler (Al₂O₃) and a boron nitride filler (BN) in a ratio of 20:45 (volume ratio) as inorganic fillers in such a manner that the sum of the alumina filler and the boron nitride filler would account for 65% by volume with respect to the total volume of the bisphenol-A type diglycidyl ether, the aromatic amine compound, and the epoxy-modified polybutadiene compound 1.

Then, methyl ethyl ketone (MEK) was added as a solvent to the obtained mixture 2 so as to yield a nonvolatile content concentration of 79% by mass, thereby preparing an epoxy resin composition 1 (slurry) having a viscosity suitable for coating.

Details of each material used in the preparation of the above mixture 1 are as follows.
- Bisphenol-A type diglycidyl ether: trade name EXE850CRP, manufactured by DIC Corporation, Mw 300 to 1500.
- Epoxy-modified polybutadiene compound 1: trade name Ricon^{®} 657E, manufactured by Cray Valley Co., Ltd., Mn about 1900, repeating units: 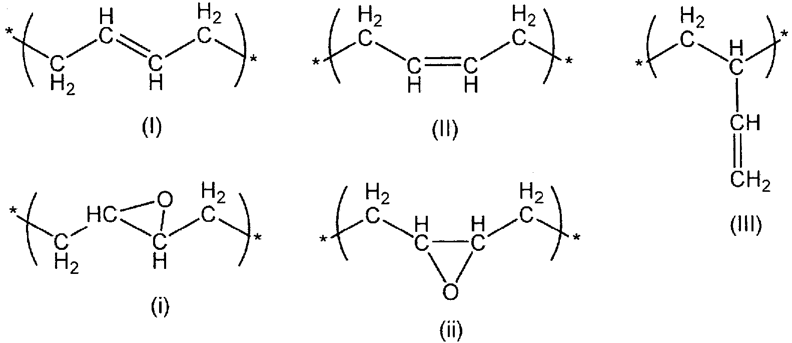
- Curing agent: diethyltoluenediamine represented by the following formula (trade name DETDA-80, manufactured by Lonza Ltd.) 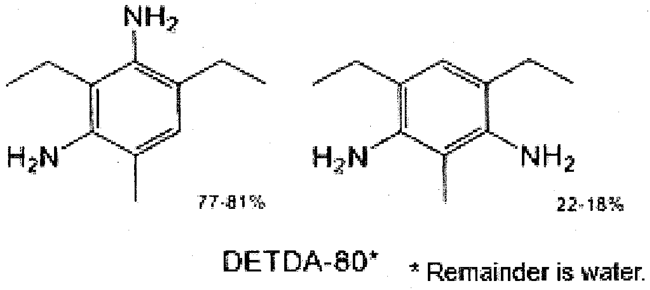
- Curing accelerator 1: triphenylphosphine triphenylborane (trade name TPP-S, manufactured by Hokko Chemical Industry Co., Ltd.) 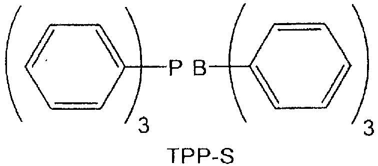
- Curing accelerator 2: triphenylphosphine (trade name TPP, manufactured by Hokko Chemical Industry Co., Ltd.)

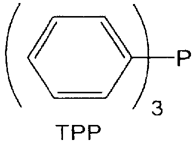

### (Example 2)

An epoxy resin composition 2 was prepared by the same method as in Example 1, except that the mixture ratio for the epoxy-modified polybutadiene compound 1 was changed to the mixture ratio shown in Table 1.

### (Example 3)

An epoxy resin composition 3 was prepared by the same method as in Example 1, except that the volume ratio (20:45) between the alumina filler (Al₂O₃) and the boron nitride filler (BN) was changed to the volume ratio shown in Table 1.

### (Example 4)

An epoxy resin composition 4 was prepared by the same method as in Example 2, except that the volume ratio (20:45) between the alumina filler (Al₂O₃) and the boron nitride filler (BN) was changed to the volume ratio shown in Table 1.

### (Comparative Example 1)

An epoxy resin composition 101 was prepared by the same method as in Example 1, except that the epoxy-modified polybutadiene compound 1 was replaced with an epoxy-modified polybutadiene compound 2 as follows.
- Epoxy-modified polybutadiene compound 2: trade name JP200, manufactured by Nippon Soda Co., Ltd., Mw 2200, repeating unit2:

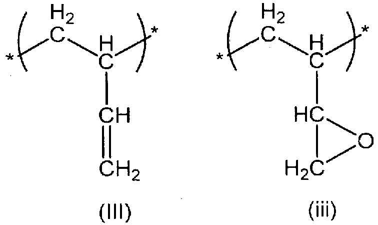

### (Comparative Example 2)

An epoxy resin composition 102 was prepared by the same method as in Comparative Example 1, except that the mixture ratio for the epoxy-modified polybutadiene compound 2 was changed to the mixture ratio shown in Table 1.

### (Comparative Example 3)

An epoxy resin composition 103 was prepared by the same method as in Comparative Example 1, except that the volume ratio (20:45) between the alumina filler (Al₂O₃) and the boron nitride filler (BN) was changed to the volume ratio shown in Table 1.

### (Comparative Example 4)

An epoxy resin composition 104 was prepared by the same method as in Comparative Example 2, except that the volume ratio (20:45) between the alumina filler (Al₂O₃) and the boron nitride filler (BN) was changed to the volume ratio shown in Table 1.

### <Verification of Phase Separation Structure>

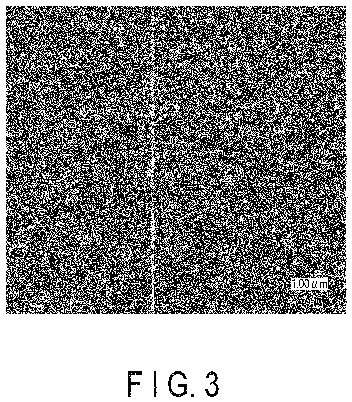

Epoxy resin compositions 1a and 101a were prepared by the same methods as in respective Example 1 and Comparative Example 1, except that no inorganic fillers were added. Fracture surfaces of the respective test pieces of the cured products of these epoxy resin compositions were observed using a microscope. The photographic image of the fracture surface of the epoxy resin composition 1a is given as FIG. 2 and the photographic image of the fracture surface of the epoxy resin composition 101a is given as FIG. 3. In both compositions, formation of the phase-separated structure was confirmed.

### <Preparation of Test Samples>

Each of the epoxy resin compositions prepared as above was applied onto a PET film using a coater and heated at 80 °C for 40 minutes to dry the solvent, thereby obtaining a dry coating film. Each of the obtained coating films was thermally transferred to a 2.0 mm thick base copper. Then, 0.5 mm thick circuit copper having φ 20 mm was superposed on the copper plate and temporarily bonded together in a face-to-face arrangement with the coating film interposed therebetween, followed by heat treatment at 185 °C for one hour, thereby obtaining a respective test sample of the metal-based circuit board including a 120 µm thick insulating layer.

### <Dynamic Mechanical Analysis (DMA)>

The base copper and the circuit copper were removed from each of the test samples by etching so that the insulating layer was taken out, thereby obtaining a 120 µm thick test piece having a width of 2 mm and a length of 60 mm. Using such test pieces, dynamic mechanical analysis was conducted (to measure the storage elastic modulus (E'), the loss elastic modulus (E"), and the loss tangent (tan δ)) under the following conditions. The glass transition temperatures Tg₁ and Tg₂ obtained from the loss tangent (tan δ) of each test piece are shown in Table 1. Note that Tg₁ refers to the glass transition temperature of the epoxy-modified butadiene rubber phase, and Tg₂ refers to the glass transition temperature of the epoxy resin phase. Note also that, among the dynamic mechanical analysis data sets obtained for the respective test pieces, the dynamic mechanical analysis data for Example 1 is set forth in the form of a graph in FIG. 1.

- Apparatus: a dynamic mechanical analyzer (manufactured by TA Instruments)
- Measurement mode: tensile mode
- Temperature increase rate: 2 °C/min
- Frequency: 1 Hz
- Atmosphere: N₂
- Temperature range: -50 °C to 300 °C

### <Adhered-state Heat Resistance>

Each test sample was left to float on a solder bath for 5 minutes so as to reach the temperature of 300 °C, and then subjected to checking by a scanning acoustic tomograph (SAT) as to whether peeling had occurred at the bonding interface between the metal-based substrate and the circuit board. This process was repeated until the peeling was recognized. The number of times the test sample had withstood the process without causing the peeling was measured (as a withstanding count), and an evaluation was made based on the following criteria. A larger withstanding count indicates a superior adhered-state heat resistance. The results are shown in Table 1.

### (Withstanding Count)

3 or more: A
2: B
0 or 1: C

### <Voltage Resistance after Soldering>

The voltage resistance of each test sample was measured after repeating the 5-minute floating on the solder bath to reach 300 °C twice in the above described adhered-state heat resistance test. Note that the voltage resistance measurement can also be conducted for the test samples that have caused the peeling under the circuit part, as long as the adhesion to the insulating layer is maintained. For the voltage resistance measurement, a voltage increase of 0.2 KV was applied every 5 seconds and the voltage at which the dielectric breakdown occurred was taken as the voltage resistance. The results are shown in Table 1.

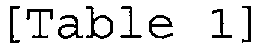

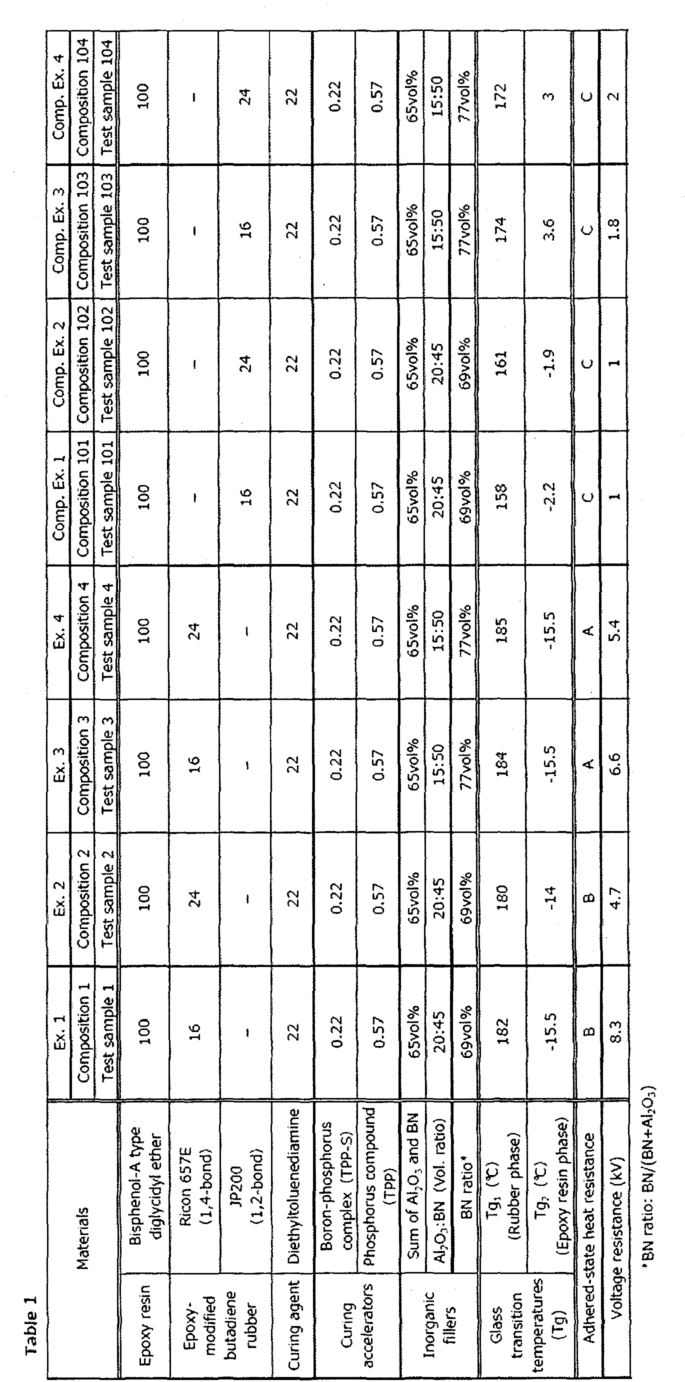

From the results shown in Table 1, it has been found that the use of a compound which further contains 1,4-bond butadiene-derived repeating units, instead of a compound containing a 1,2-bond butadiene-derived repeating unit, as the epoxy-modified polybutadiene compound can realize an excellent adhered-state heat resistance and also allow for the retention of voltage resistance at a high level.

### REFERENCE SIGNS LIST

- 10: Laminate for circuit board
- 11: Metal substrate
- 12: Insulating layer
- 13: Metal foil
- 13a: Circuit pattern
- 20: Metal-based circuit board
- 100: Power module
- 110: Conventional power module
- 101: Power device
- 102: Solder layer
- 102a: First solder layer
- 102b: Second solder layer
- 103: Heat dissipation sheet
- 104: Heat sink
- 105: Ceramic substrate
- 106: Metallized layer

## Claims

1. An epoxy resin composition for interlayer insulation comprising an epoxy resin, an epoxy-modified polybutadiene compound, and an aromatic amine compound,
wherein the epoxy-modified polybutadiene compound contains a repeating unit represented by the following general formula (I), a repeating unit represented by the following general formula (II), and a repeating unit represented by the following general formula (III), and contains at least one of a repeating unit represented by the following general formula (i), a repeating unit represented by the following general formula (ii), and a repeating unit represented by the following general formula (iii) :

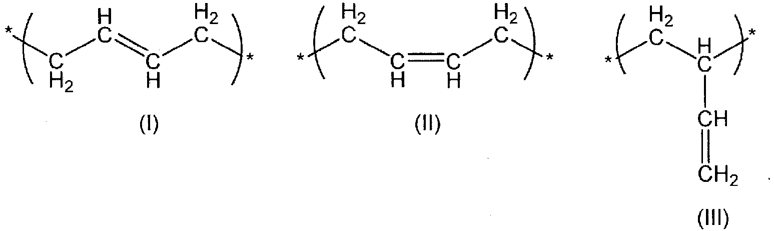

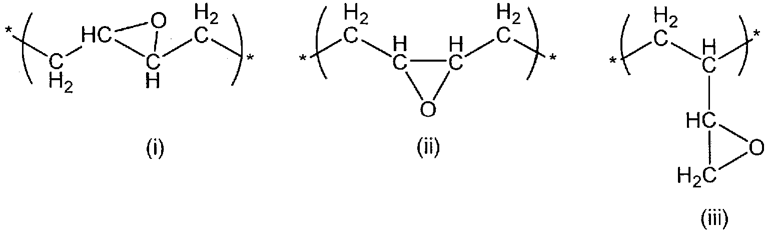

2. The epoxy resin composition for interlayer insulation according to claim 1, at least comprising, as the epoxy resin, a bisphenol-A type diglycidyl ether.

3. The epoxy resin composition for interlayer insulation according to claim 1 or 2, comprising, as the aromatic amine compound, a compound represented by the following general formula (IV): 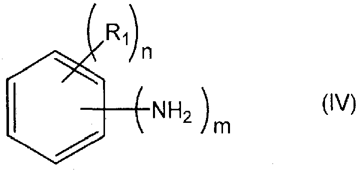
in which R₁ represents an alkyl group, m represents an integer of 2 or more, n represents an integer of 0 or more, and m and n satisfy m + n ≤ 6,
wherein if n is 2 or more, a plurality of R₁'s may be the same as or different from one another.

4. The epoxy resin composition for interlayer insulation according to any one of claims 1 to 3, comprising a boron-phosphorus complex represented by the following general formula (V) and a phosphorus compound represented by the following general formula (VI): 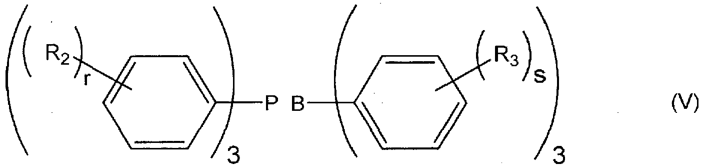
wherein in the general formula (V), R₂ and R₃ each independently represent an alkyl group, r represents an integer of 0 or more and 5 or less, and s represents an integer of 0 or more and 5 or less,
wherein if r is an integer of 2 or more, a plurality of R₂'s may be the same as or different from one another, and
if s is an integer of 2 or more, a plurality of R₃'s may be the same as or different from each other, and 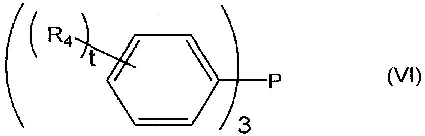
in the general formula (VI), R₄ represents an alkyl group or an alkoxy group, and t represents an integer of 0 or more and 5 or less,
wherein if t is an integer of 2 or more, a plurality of R₄'s may be the same as or different from one another.

5. The epoxy resin composition for interlayer insulation according to any one of claims 1 to 4, comprising an inorganic filler.

6. The epoxy resin composition for interlayer insulation according to claim 5, comprising, as the inorganic filler, at least boron nitride,
wherein a ratio of the inorganic filler to a total volume of the epoxy resin, the epoxy-modified polybutadiene compound, and the aromatic amine compound is 50% by volume or more and 85% by volume or less, and
a ratio of the boron nitride to the inorganic filler is 60% by volume or more.

7. A resin sheet for interlayer insulation comprising a cured product of the epoxy resin composition for interlayer insulation according to any one of claims 1 to 6,
wherein the resin sheet for interlayer insulation has a phase-separated structure in which a discontinuous phase containing the epoxy-modified polybutadiene compound is dispersed in a continuous phase containing the epoxy resin, determined as indicated in the description.

8. The resin sheet for interlayer insulation according to claim 7, wherein
a first glass transition temperature Tg₁ attributable to the epoxy-modified polybutadiene compound is -5 °C or lower, and
a second glass transition temperature Tg₂ attributable to the epoxy resins is 175 °C or higher, wherein the glass transition temperatures are measured as indicated in the description.

9. A laminate for a circuit board, the laminate comprising a metal substrate, an insulating layer provided on at least one surface of the metal substrate, and a metal foil provided on the insulating layer,
wherein the insulating layer is the resin sheet for interlayer insulation according to claim 7 or 8.

10. A metal-based circuit board comprising a metal substrate, an insulating layer provided on at least one surface of the metal substrate, and a circuit pattern provided on the insulating layer,
wherein the insulating layer is the resin sheet for interlayer insulation according to claim 7 or 8.

11. A power module comprising the metal-based circuit board according to claim 10.

## Patentansprüche

1. Epoxidharzzusammensetzung für Zwischenschichtisolierungen, die ein Epoxidharz, eine epoxidmodifizierte Polybutadienverbindung und eine aromatische Aminverbindung umfasst,
wobei die epoxidmodifizierte Polybutadienverbindung eine durch die folgende allgemeine Formel (I) dargestellte Wiederholeinheit, eine durch die folgende allgemeine Formel (II) dargestellte Wiederholeinheit und eine durch die folgende allgemeine Formel (III) dargestellte Wiederholeinheit enthält sowie mindestens eine von einer durch die folgende allgemeine Formel (i) dargestellten Wiederholeinheit, einer durch die folgende allgemeine Formel (ii) dargestellten Wiederholeinheit und einer durch die folgende allgemeine Formel (iii) dargestellten Wiederholeinheit enthält:

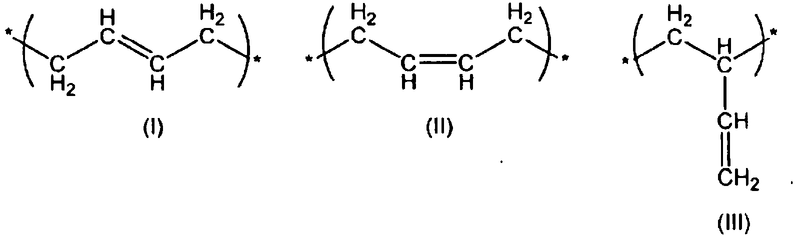

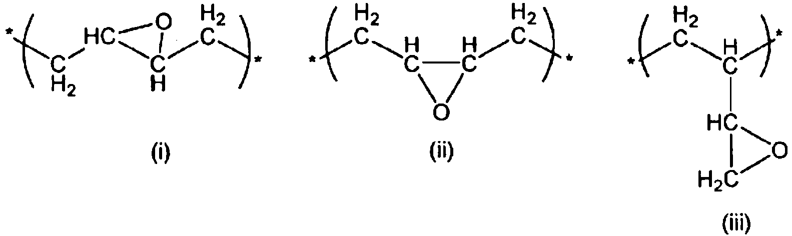

2. Epoxidharzzusammensetzung für Zwischenschichtisolierungen nach Anspruch 1, die als Epoxidharz mindestens einen Diglycidylether vom Bisphenol-A-Typ umfasst.

3. Epoxidharzzusammensetzung für Zwischenschichtisolierungen nach Anspruch 1 oder 2, die als aromatische Aminverbindung eine durch die folgende allgemeine Formel (IV) dargestellte Verbindung umfasst: 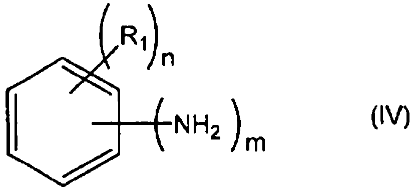
wobei R₁ eine Alkylgruppe darstellt, m eine Ganzzahl von 2 oder mehr darstellt, n eine Ganzzahl von 0 oder mehr darstellt und m und n m + n ≤ 6 erfüllen,
wobei, wenn n 2 oder mehr ist, eine Vielzahl von R₁ gleich oder voneinander verschieden sein kann.

4. Epoxidharzzusammensetzung für Zwischenschichtisolierungen nach einem der Ansprüche 1 bis 3, die einen durch die folgende allgemeine Formel (V) dargestellten Bor-Phosphor-Komplex und eine durch die folgende allgemeine Formel (VI) dargestellte Phosphorverbindung umfasst: 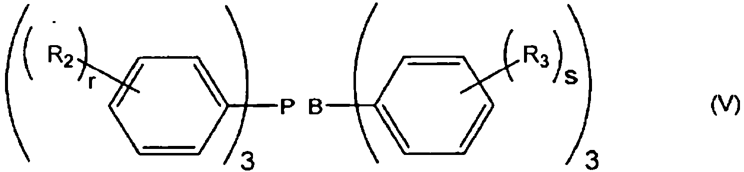
wobei in der allgemeinen Formel (V) R₂ und R₃ jeweils unabhängig voneinander eine Alkylgruppe darstellen, r eine Ganzzahl von 0 oder mehr und 5 oder weniger darstellt und s eine Ganzzahl von 0 oder mehr und 5 oder weniger darstellt,
wobei, wenn r eine Ganzzahl von 2 oder mehr ist, eine Vielzahl von R₂ gleich oder voneinander verschieden sein kann, und
wenn s eine Ganzzahl von 2 oder mehr ist, eine Vielzahl von R₃ gleich oder voneinander verschieden sein kann, und 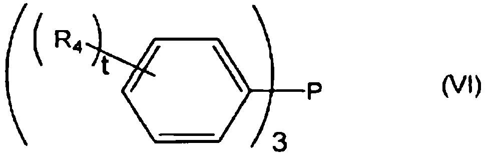
in der allgemeinen Formel (VI) R₄ eine Alkylgruppe oder eine Alkoxygruppe darstellt und t eine Ganzzahl von 0 oder mehr und 5 oder weniger darstellt, wobei, wenn t eine Ganzzahl von 2 oder mehr ist, eine Vielzahl von R₄ gleich oder verschieden voneinander sein kann.

5. Epoxidharzzusammensetzung für Zwischenschichtisolierungen nach einem der Ansprüche 1 bis 4, die einen anorganischen Füllstoff umfasst.

6. Epoxidharzzusammensetzung für Zwischenschichtisolierungen nach Anspruch 5, die als anorganischen Füllstoff mindestens Bornitrid umfasst, wobei ein Verhältnis des anorganischen Füllstoffs zu einem Gesamtvolumen des Epoxidharzes, der epoxidmodifizierten Polybutadienverbindung und der aromatischen Aminverbindung 50 Vol.-% oder mehr und 85 Vol.-% oder weniger beträgt, und
ein Verhältnis des Bornitrids zu dem anorganischen Füllstoff 60 Vol.-% oder mehr beträgt.

7. Harzfolie für Zwischenschichtisolierungen, die ein gehärtetes Produkt aus der Epoxidharzzusammensetzung für Zwischenschichtisolierungen nach einem der Ansprüche 1 bis 6 umfasst,
wobei die Harzfolie für Zwischenschichtisolierungen eine phasengetrennte Struktur aufweist, in der eine diskontinuierliche Phase, die die epoxidmodifizierte Polybutadienverbindung enthält, in einer kontinuierlichen Phase, die das Epoxidharz enthält, dispergiert ist, wie in der Beschreibung angegeben.

8. Harzfolie für Zwischenschichtisolierungen nach Anspruch 7, wobei
eine erste Glasübergangstemperatur Tg₁, die der epoxidmodifizierten Polybutadienverbindung zugeordnet werden kann, -5 °C oder niedriger ist, und
eine zweite Glasübergangstemperatur Tg₂, die den Epoxidharzen zugeordnet werden kann, 175 °C oder höher ist, wobei die Glasübergangstemperaturen wie in der Beschreibung angegeben gemessen werden.

9. Laminat für eine Leiterplatte, wobei das Laminat ein Metallsubstrat, eine Isolierschicht, die auf mindestens einer Oberfläche des Metallsubstrats vorgesehen ist, und eine Metallfolie, die auf der Isolierschicht vorgesehen ist, umfasst,
wobei die Isolierschicht die Harzfolie für Zwischenschichtisolierungen nach Anspruch 7 oder 8 ist.

10. Leiterplatte auf Metallbasis, umfassend ein Metallsubstrat, eine Isolierschicht, die auf mindestens einer Oberfläche des Metallsubstrats vorgesehen ist, und ein Schaltungsmuster, das auf der Isolierschicht vorgesehen ist,
wobei die Isolierschicht die Harzfolie für Zwischenschichtisolierungen nach Anspruch 7 oder 8 ist.

11. Leistungsmodul, das die Leiterplatte auf Metallbasis nach Anspruch 10 umfasst.

## Revendications

1. Composition de résine époxy pour une isolation inter-couche, comprenant une résine époxy, un composé de polybutadiène modifié par époxy, et un composé d'amine aromatique,
dans lequel le composé de polybutadiène modifié par époxy contient une unité de répétition représentée par la formule générale (I) ci-dessous, une unité de répétition représentée par la formule générale (II) ci-dessous, et une unité de répétition représentée par la formule générale (III) ci-dessous, et contient l'une au moins parmi une unité de répétition représentée par la formule générale (i) ci-dessous, une unité de répétition représentée par la formule générale (ii) ci-dessous et une unité de répétition représentée par la formule générale (iii) ci-dessous :

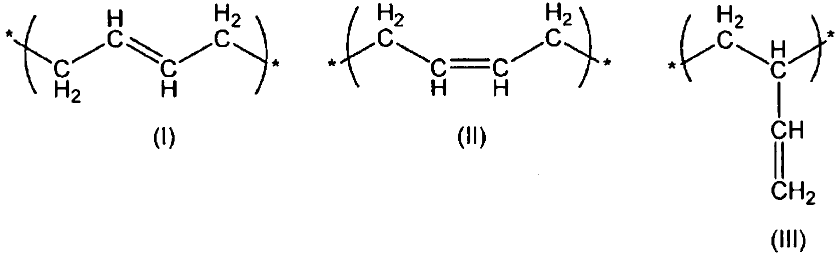

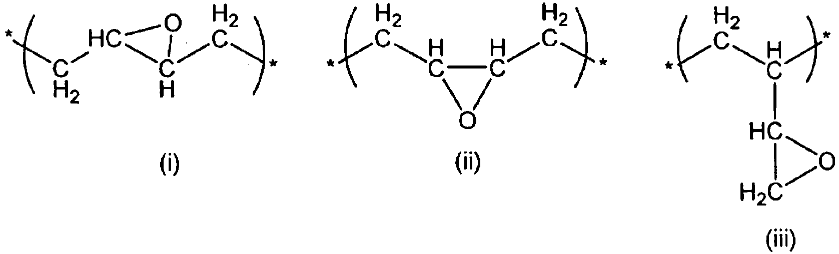

2. Composition de résine époxy pour une isolation inter-couche selon la revendication 1, comprenant au moins, en tant que résine époxy, un éther de diglycidyle de type bisphénol A.

3. Composition de résine époxy pour une isolation inter-couche selon la revendication 1 ou 2, comprenant, en tant que composé d'amine aromatique, un composé représenté par la formule générale (IV) ci-dessous : 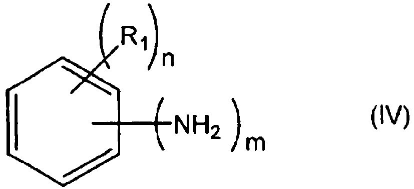
où R₁ représente un groupe alkyle, m représente un nombre entier de 2 ou plus, n représente un nombre entier de 0 ou plus, et m et n satisfont m + n ≤ 6,
dans laquelle, si n est égal à 2 ou plus, une pé de R₁ peuvent être identiques ou différents les uns des autres.

4. Composition de résine époxy pour une isolation inter-couche selon l'une quelconque des revendications 1 à 3, comprenant un complexe bore-phospore représenté par la formule générale (V) ci-dessous et un composé de phosphore représenté par la formule générale (VI) ci-dessous : 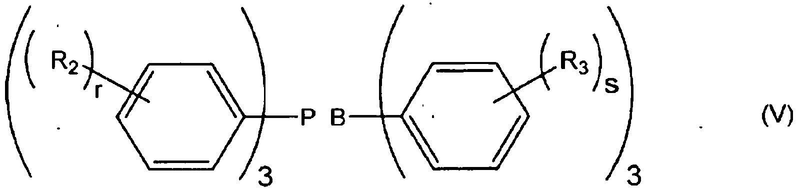
dans laquelle, dans la formule générale (V), R₂ et R₃ représentent chacun indépendamment un groupe alkyle, r représente un nombre entier de 0 ou plus et de 5 ou moins, et s représente un nombre entier de 0 ou plus et de 5 ou moins,
dans laquelle, si r est un nombre entier de 2 ou plus, une pluralité de R₂ peuvent être identiques ou différents les uns des autres, et
si s est un nombre entier de 2 ou plus, une pluralité de R₃ peuvent être identiques ou différents les uns des autres, et 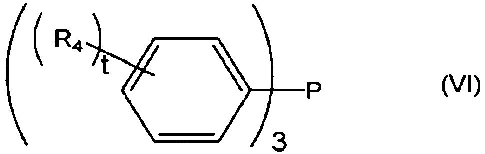
dans la formule générale (VI), R₄ représente un groupe alkyle ou un groupe alkoly, et t représente un nombre entier de 0 ou plus et de 5 ou moins,
dans laquelle, si t est un nombre entier de 2 ou plus, une pluralité de R₄ peuvent être identiques ou différents les uns des autres.

5. Composition de résine époxy pour une isolation inter-couche selon l'une quelconque des revendications 1 à 4, comprenant un agent de charge inorganique.

6. Composition de résine époxy pour une isolation inter-couche selon la revendication 5, comprenant, en tant qu'agent de charge inorganique, au moins du nitrure de bore,
dans laquelle un rapport de l'agent de charge inorganique à un volume total de la résine époxy, du composé de polybutadiène modifié par époxy et du composé d'amine aromatique est de 50 % en volume ou plus et de 85 % en volume ou moins, et
un rapport du nitrure de bore à l'agent de charge inorganique est de 60 % en volume ou plus.

7. Feuille de résine pour une isolation inter-couche comprenant un produit durci de la composition de résine époxy pour une isolation inter-couche selon l'une quelconque des revendications 1 à 6,
dans laquelle la feuille de résine pour une isolation inter-couche comporte une structure à phases séparées, dans lequel une phase discontinue contenant le composé de polybutadiène modifié par époxy est dispersée dans une phase continue contenant la résine époxy, conformément à la description.

8. Feuille de résine pour une isolation inter-couche selon la revendication 7, dans laquelle
une première température de transition vitreuse Tg₁ attribuable au composé de polybutadiène modifié par époxy est de -5 °C ou moins, et
une deuxième température de transition vitreuse Tg₂ attribuable aux résines époxy est de 175 °C ou plus, les température de transition vitreuse étant mesurées conformément à la description.

9. Stratifié pour carte de circuit imprimé, le stratifié comprenant un substrat métallique, une couche isolante disposée sur au moins une surface du substrat métallique, et un film métallique disposé sur la couche isolante,
dans lequel la couche isolante est la feuille de résine pour une isolation inter-couche selon la revendication 7 ou 8.

10. Carte de circuit imprimé à base de métal comprenant un substrat métallique, une couche isolante disposée sur au moins une surface du substrat métallique, et une configuration de circuit disposée sur la couche isolante,
dans laquelle la couche isolante est la feuille de résine pour une isolation inter-couche selon la revendication 7 ou 8.

11. Module d'alimentation comprenant la carte de circuit imprimé à base de métal selon la revendication 10.
